# FASCICULE DE BREVET EUROPEEN

(11) **EP 1 634 103 B1**
(45) Date de publication et mention de la délivrance du brevet: **17.01.2007**
(21) Numéro de dépôt: 04739492.9
(22) Date de dépôt: 01.06.2004
(51) Int. Cl.: G01T 1/202, C09K 11/85

(54) **CRISTAUX SCINTILLATEURS DU TYPE IODURE DE TERRE RARE**
SELTENERD-IODID-SZINTILLATIONSKRISTALLE
RARE-EARTH IODIDE SCINTILLATION CRYSTALS

(30) Priorité: 05.06.2003 FR 0306822
(43) Date de publication de la demande: 15.03.2006
(73) Titulaire: Stichting voor de Technische Wetenschappen, 3527 JP Utrecht (NL); Université de Bern, 3012 Bern (CH)
(72) Inventeur: DORENBOS, Pieter, NL-2281 GM Rijswijk (NL); VAN EIJK, Carel, Wilhelm, Eduard, NL-2625 LS Delft (NL); GUDEL, Hans-Ulrich, 3174 Thorisaus (CH); VAN LOEF, Edgar, Valentijn, Dieuwer, NL-3071 AP Rotterdam (NL); KRAMER, Karl, Wilhelm, 3012 Berne (CH)
(74) Mandataire: Colombier, Christian
(86) Numéro de dépôt international: PCT/EP2004/005899
(87) Numéro de publication internationale: WO 2004/109333

(56) Documents cités:
- DATABASE WPI Section Ch, Week 200370 Derwent Publications Ltd., London, GB; Class K08, AN 2003-737191 XP002267161 & JP 2003 232895 A (KONICA CORP) 22 août 2003 (2003-08-22)
- DATABASE CHEMABS [Online] CHEMICAL ABSTRACTS SERVICE, COLUMBUS, OHIO, US; 13 juillet 2003 (2003-07-13), VAN LOEF, E. V. D. ET AL: "Influence of the anion on the spectroscopy and scintillation mechanism in pure and Ce3+-doped K2LaX5 and LaX3 (X=Cl, Br, I)" XP002267160 extrait de STN Database accession no. 139:387873 & PHYSICAL REVIEW B: CONDENSED MATTER AND MATERIALS PHYSICS , 68(4), 045108/1-045108/9 CODEN: PRBMDO; ISSN: 0163-1829, 2003,

## Description

L'invention concerne des cristaux scintillateurs inorganiques du type iodure de terre rare, un procédé de fabrication permettant de les obtenir et l'utilisation desdits cristaux, notamment dans des détecteurs pour rayons gamma et/ou rayons X.

Les cristaux scintillateurs sont largement utilisés dans des détecteurs pour rayons gamma, rayons X, rayons cosmiques et particules dont l'énergie va notamment de 1 KeV à 10 MeV.

Un cristal scintillateur est un cristal transparent dans le domaine de longueur d'onde de scintillation, qui répond à une radiation incidente par l'émission d'une impulsion lumineuse. L'impulsion lumineuse dépend du cristal et est la plus intense possible. Cette impulsion est rapportée à l'energie incidente absorbée par le matériau et est exprimée en photons par MeV absorbés. On cherche des cristaux dont l'intensité d'émission est la plus intense possible.

A partir de tels cristaux, généralement de monocristaux, on peut fabriquer des détecteurs où la lumière émise par le cristal que comprend le détecteur, est couplée à un moyen de détection de la lumière (ou photodétecteur comme un photomultiplicateur), lequel produit un signal électrique proportionnel au nombre d'impulsions lumineuses reçu et à leur intensité. De tels détecteurs sont utilisés notamment dans l'industrie pour des mesures d'épaisseur ou de grammage, dans les domaines de la médecine nucléaire, de la physique, de la chimie, de la recherche pétrolière.

Un autre paramètre recherché pour le matériau scintillateur est son pouvoir d'arrêt des rayons X ou gamma, qui est au premier ordre une fonction de ρ.Z⁴ (p étant la densité, Z le numéro atomique effectif du composé). Un second critère est son rendement lumineux par photon incident absorbé, exprimé dans la suite du texte en Photons / MeV à 662 keV, énergie de l'émission gamma principale du ¹³⁷Cs.

Un des autres paramètres que l'on cherche à améliorer est la résolution en énergie.

En effet, dans la plupart des applications des détecteurs nucléaires (détection des rayons X, α, β, gamma, électrons, neutrons, particules chargées), une bonne résolution en énergie est souhaitée. La résolution en énergie d'un détecteur de rayonnement nucléaire détermine en effet sa capacité à séparer des énergies de rayonnement très voisines. Elle est usuellement déterminée pour un détecteur donné à une énergie incidente donnée, comme la largeur à mi-hauteur du pic considéré sur un spectre en énergie obtenu à partir de ce détecteur, rapportée à l'énergie à la centroide du pic (voir notamment : G.F Knoll, "Radiation Detection and Measurement", John Wiley and Sons, Inc, 2^{nd} édition, p 114). Dans la suite du texte, et pour toutes les mesures effectuées, la résolution est déterminée à 662 keV, énergie de l'émission gamma principale du ¹³⁷Cs.

Plus la résolution en énergie est un petit nombre, meilleure est la qualité du détecteur. On considère que des résolutions en énergie de l'ordre de 7 % permettent déjà d'obtenir de bons résultats, mais l'on cherche toujours à améliorer ce paramètre. En effet, à titre d'exemple, dans le cas d'un détecteur utilisé pour analyser différents isotopes radioactifs, une meilleure résolution en énergie permet une meilleure distinction de ces isotopes. Une amélioration de la résolution en énergie (se traduisant par une valeur plus faible de résolution) est aussi particulièrement avantageuse pour un dispositif d'imagerie médicale par exemple de type Gamma camera d'Anger ou Tomographe à Emission de Positons (TEP), car elle permet d'améliorer fortement le contraste et la qualité des images, permettant ainsi une détection plus précise et plus précoce des tumeurs.

Un autre paramètre très important est la constante de temps de décroissance de la scintillation (dite " decay time "), ce paramètre est usuellement mesuré par la méthode dite "Start Stop" ou "Multi hit méthod", (décrite par W.W Moses dans Nucl. Instr and Meth. A336 (1993) 253). Une constante de temps de décroissance la plus faible possible est souhaitée, de façon à pouvoir augmenter la fréquence de fonctionnement des détecteurs. Dans le domaine de l'imagerie médicale nucléaire, ceci permet par exemple de réduire considérablement les durées d'examens. Une constante de temps de décroissance peu élevée permet de plus d'améliorer la résolution temporelle des dispositifs détectant des évènements en coïncidence temporelle. C'est le cas des TEP, où la réduction de la constante de temps de décroissance du scintillateur permet d'améliorer significativement les images en rejetant avec plus de précision les évènements non coïncidents.

Une famille de cristaux scintillateurs connus et utilisés largement est du type iodure de sodium dopé au thallium, Nal (Tl). Ce matériau scintillateur découvert en 1948 par Robert Hofstadter et qui est à la base des scintillateurs modernes reste encore le matériau prédominant dans ce domaine malgré près de 50 années de recherches sur d'autres matériaux. Son rendement lumineux est de 38 000 - 40 000 photons / MeV. Cependant ces cristaux ont une décroissance de scintillation lente d'environ 230 ns. De plus, leur résolution en énergie reste moyenne (de l'ordre de 7% sous irradiation de ¹³⁷Cs ), ainsi que leur pouvoir d'arrêt (ρ*Z⁴ = 24.10⁶).

Un matériau également utilisé est le Csl, qui en fonction des applications peut être utilisé pur, ou dopé soit avec du Thallium (Tl) soit avec du Sodium (Na). Cependant, Csl(Tl) et Csl(Na) ont des constantes de temps de décroissance élevées, notamment supérieures à 500 ns.

Une famille de cristaux scintillateurs qui a connu un grand développement est du type germanate de bismuth (BGO), notamment en raison de son fort pouvoir d'arrêt. Cependant, les cristaux de la famille BGO ont des constantes de temps de décroissance élevées, qui limitent l'emploi de ces cristaux à de faibles taux de comptage. De plus, leur rendement lumineux (exprimé en nombre de photons par MeV absorbés) reste 4 à 5 fois inférieur à celui des cristaux de Nal :Tl, de l'ordre de 8 000 - 9 000 photons / MeV.

Une famille plus récente de cristaux scintillateurs a été développée dans les années 1990 et est du type oxyorthosilicate de Lutécium activé au cérium LSO(Ce). Cependant ces cristaux sont très hétérogènes et ont des points de fusion très élevés (environ 2200°C). Leur résolution énergétique n'est pas excellente et excède la plupart du temps 10% sous ¹³⁷Cs.

On connaît également XLn₂Cl₇ et XLn₂Br₇ ces deux familles étant dopées au cérium, avec X représentant un alcalin, notamment Cs ou Rb, Ln une terre rare. De ces composés, le RbGd₂Br₇:Ce est le plus attractif mais il est onéreux. D'autre part, Rb présente un bruit de fond de radiation important du fait de l'isotope ⁸⁷Rb, ce qui altère la qualité du signal de sortie du scintillateur. D'autres efforts ont porté sur K₂LaCl₅:Ce (voir Hans van't Spijker et al., [Rad. Meas. 24(4) (1995) 379-381], [J. Lumin. 85 (1999) 1-10]). Son rendement lumineux est cependant deux fois inférieur à celui du Nal:Tl (20 000 ph/MeV) et l'émission lumineuse du matériau contient une composante lente. De plus, son pouvoir d'arrêt des rayons X ou gamma incidents est faible (ρ*Z⁴ = 11.10⁶).

WO 0160944 et WO 0160945 enseignent que les compositions respectivement de type Ln₁₋ₓCeₓCl₃ et Ln₁₋ₓCeₓBr₃ où Ln est choisi parmi les lanthanides ou les mélanges de lanthanides et où x est le taux molaire de substitution de Ln par du cérium, et notamment LaCl₃:Ce et LaBr₃:Ce, présentent un temps de décroissance rapide avec une composante rapide de 25-35 ns et une excellente résolution en énergie atteignant 2.9-3.1%. Cependant, leur pouvoir d'arrêt reste modéré, notamment égal à 25.10⁶ pour LaBr3 :0.5%Ce.

L'article publié dans Journal of luminescence 85, 1999, 21-35 (Guillot-Noël et al) enseigne qu'un cristal de LuCl₃ dopé à 0,45% en Ce présente une intensité d'émission de 5700 photons/MeV à 662 keV et une résolution en énergie de 18%. Il enseigne également qu'un cristal de LuBr₃ dopé à 0,46% en Ce présente une intensité d'émission de 18000 photons/MeV à 662 keV et une résolution en énergie de 8%.

L'invention concerne un matériau scintillateur inorganique du type iodure de formule AₓLn_{(y-y')}Ln'_{y'}I_{(x+3y)} dans laquelle
- A représente au moins un élément choisi parmi Li, Na, K, Rb, Cs,
- Ln représente au moins une première terre rare choisie parmi La, Gd, Y, Lu, ladite première terre rare étant de valence 3+ dans ladite formule,
- Ln' représente au moins une deuxième terre rare choisie parmi Ce, Tb, Pr, ladite deuxième terre rare étant de valence 3+ dans ladite formule, (cette deuxième terre rare est aussi nommée dopant dans la suite)
- x est entier et représente 0, 1, 2 ou 3,
- y est entier ou non entier et supérieur à 0 et inférieur à 3,
- y' est entier ou non entier, supérieur à 0 et inférieur à y.

Le matériau selon l'invention présente, un fort pouvoir d'arrêt, un temps de décroissance rapide, notamment inférieur à 100 ns, une bonne résolution en énergie (notamment inférieure à 6% à 662 keV) et un niveau lumineux élevé.

Le matériau selon l'invention peut comprendre des impuretés usuelles dans le domaine technique de l'invention. Les impuretés usuelles sont en général des impuretés provenant des matières premières dont le taux massique est notamment inférieur à 0,1%, voire même inférieur à 0,01%, et/ou des phases parasites (par exemple la phase Kl dans K₂Lal₅) dont le pourcentage volumique est notamment inférieur à 1 %.

En tant que Ln' dans la formule ci-dessus, on préfère Ce, puis Tb, puis Pr.

De manière préférée, y' va de 0,001 y à 0,9 y (ce qui signifie que le taux de substitution molaire de Ln par Ln' va de 0,1% à 90%), et va de manière encore préférée de 0,001 y à 0,1 y , et même de 0,001 y à 0,01 y. Notamment, y' peut aller de 0,003 y à 0,01 y. Notamment, on peut avoir y=1. Pour le cas ou Ln est La, on préfère que x soit non nul.

Comme matériau selon l'invention, on peut citer :
- K₂La_{(1-y')}Ce_{y},I₅
- K₂La_{(1-y')}Tb_{y},I₅
- Lu_{(1-y')}Ce_{y},I₃
- Lu_{(1-y')}Tb_{y},I₃
- Cs₃La_{(1-y')}Ce_{y},I₆
- Cs₃La_{(1-y')}Tb_{y},I₆
- Cs₃Lu_{(1-y')}Ce_{y},I₆
- Cs₃Lu_{(1-y')}Tb_{y},I₆
- Cs₃LU_{(2-y')}Ce_{y},I₉
- Cs₃Lu_{(2-y')}Tb_{y},I₉
- Na₃Gd_{(1-y')}Ce_{y},I₆
- Na₃Gd_{(1-y')}Tb_{y},I₆
- K₃Gd_{(1-y')}Ce_{y'}I₆
- K₃Gd_{(1-y')}Tb_{y'}I₆
- Cs₃Gd_{(1-y')}Ce_{y},I₆
- Cs₃Gd_{(1-y')}Tb_{y'}I₆
- Cs₃Gd_{(2-y')}Ce_{y},I₉
- Cs₃Gd_{(2-y')}Tb_{y},I₉
- K₃Lu_{(1-y')}Ce_{y'}I₆
- K₃Lu_{(1-y')}Tb_{y},I₆
- Cs₃Lu_{(2-y')}Ce_{y'}I₉
- Cs₃Lu_{(2-y')}Tb_{y'}I₉
- K₃Y_{(1-y')}Ce_{y},I₆
- K₃Y_{(1-y')}Tb_{y'}I₆
- Cs₃Y_{(1-y')}Ce_{y'}I₆
- Cs₃Y_{(1-y')}Tb_{y'}I₆
- Cs₃Y_{(2-y')}Ce_{y'}I₉
- Cs₃Y_{(2-y')}Tb_{y,}I₉

Les matériaux K₂La_{(1-y')}Ce_{y'}I₅ et Lu_{(1-y')}Ce_{y'}I₃ sont particulièrement adaptés.

Le matériau selon l'invention peut d'autre part être optimisé en fonction de considérations sur les niveaux d'énergie électroniques. Si l'on considère notamment la transition d'énergie responsable du pic d'émission, on constate que la position de ces niveaux d'énergie dans la bande interdite a une grande importance. Ceci peut constituer une règle de préférence pour certains des composés selon l'invention.

Selon un mode de réalisation le matériau scintillateur selon l'invention est un monocristal permettant d'obtenir des pièces d'une grande transparence dont les dimensions sont suffisantes pour arrêter et détecter efficacement les rayonnements à détecter, y compris à haute énergie ( notamment supérieure à 100 keV). Le volume de ces monocristaux est notamment de l'ordre de 10 mm³, voire supérieur à 1 cm³ et même supérieur à 10 cm³.

Selon un autre mode de réalisation, le matériau scintillateur selon l'invention est une poudre cristallisée ou un polycristal par exemple sous la forme de poudres mélangées avec un liant ou bien sous forme de sol-gel.

Le matériau selon l'invention peut notamment être obtenu sous forme de monocristal par une croissance du type Bridgman vertical, par exemple en ampoules de quartz scellées sous vide. La fusion / cristallisation est du type congruente.

Le matériau selon l'invention peut notamment servir de composant d'un détecteur de rayonnement notamment de rayons gamma et/ou rayons X.

Un tel détecteur comprend notamment un photodétecteur couplé optiquement au scintillateur pour produire un signal électrique en réponse à l'émission d'une impulsion de lumière produite par le scintillateur. Le photodétecteur du détecteur peut notamment être un photomultiplicateur, ou bien une photodiode, ou bien un capteur CCD (de l'anglais « Charge Coupled Device »).

L'utilisation préférée de ce type de détecteur porte sur la mesure de rayonnements gamma ou X mais un tel système est également susceptible de détecter les rayonnements Alpha, Beta et les électrons. L'invention concerne également l'utilisation du détecteur ci-dessus dans les appareils de médecine nucléaire, notamment les Gamma caméras de type Anger et les scanners à Tomographie d'Emission de Positons (voir par exemple C.W.E. Van Eijk, " Inorganic Scintillator for Medical Imaging ", International Seminar New types of Detectors, 15-19 May 1995 - Archamp, France. Publié dans "Physica Medica", Vol XII, supplément 1, Juin 96).

Selon une autre variante, l'invention concerne l'utilisation du détecteur ci-dessus dans les appareils de détection pour forage pétrolier, (voir par exemple " Applications of scintillation counting and analysis ", dans " Photomultiplier tube, principle and application", chapitre 7, Philips).

### EXEMPLES

On synthétise K₂LaI₅ selon l'invention, K₂LaCl₅, K₂LaBr₅ comme exemples comparatifs et Lul₃ selon l'invention. Tous les échantillons sont dopés au cérium (0.7% pour y' au sens de la formule AₓLn_{(y-y')}Ln'_{y'}I_{(x+3y)} pour les trois premiers composés et 0.5 % pour Lul₃).

Comme constituants de départ pour K₂Lal₅, K₂LaCl₅, K₂LaBr₅, on a utilisé :
- KCI, KBr, Kl (Merck, suprapur),
- LaCl₃/Br₃ et CeCl₃/Br₃ qui étaient préparés à partir de La₂O₃ par la méthode des halogénures d'ammonium ;
- Lal₃, et Cel₃ qui étaient synthétisés à partir des elements (La, K et I) selon la méthode décrite par G.Meyer dans "Synthesis of Lanthanides and Actinides compounds", edited by G.Meyer and L.Morss (Kluwer, Dordrecht, 1991), p 145.

Lul₃ et Cel₃, eux, ont été synthétisés à partir des éléments, respectivement Lu et I d'une part, Ce et I d'autre part.

Pour enlever les traces de l'eau et d'oxygène, les constituants ont été purifiés par sublimation dans des ampoules de tantale ou de silice. Pour la croissance du monocristal des quantités stoechiométriques des produits de départ ont été scellées dans une ampoule de silice sous vide. La manipulation de tout ingrédient ou matériau a été faite sous atmosphère inerte, notamment dans des boîtes à gants contenant moins de 0,1 ppm d'eau.

Les échantillons utilisés pour les exemples sont des petits monocristaux, de volume de l'ordre de 10 mm³. Les mesures sont effectuées sous une excitation de rayon y à 662 keV. L'intensité d'émission est exprimée en photons par MeV. Les temps de décroissance de la scintillation ont été mesurés par la méthode dite "Multi Hit" décrite décrite par W.W Moses ( Nucl. Instr and Meth. A336 (1993) 253. Les cristaux ont été montés sur des Photomultiplicateurs Philips XP2020Q. La composante rapide de scintillation a été caractérisée par sa constante de temps de décroissance ou " decay time ", τ, exprimée en nanosecondes, et par son intensité de scintillation qui représente la contribution de cette composante au nombre total de photons émis par le scintillateur (dernière colonne du Tableau). Le temps de fenêtrage de l'acquisition du signal est de 10 µs.

On constate sur l'exemple 3 que le composé K₂Lal₅:Ce selon l'invention de type iodure de terre rare comprenant 0,7 % en mole de cérium (base terres rares, soit y' = 0,007) présente une constante de temps de décroissance de la composante rapide de fluorescence de 65 ns (pour 230 ns pour le Nal :Tl). Le tableau 1 présente les autres résultats de scintillation. Dans le cas du matériau de l'exemple 3 selon l'invention, l'intensité de scintillation de la composante rapide est remarquable et supérieure à 30 000 photons / MeV. En outre la résolution en énergie sous ¹³⁷Cs à 662 keV est significativement améliorée par rapport à celle du Nal : TI (exemple 4 comparatif), avec des valeurs de l'ordre de 5%. Le matériau iodure de terre rare selon l'invention offre des avantages significatifs sur le plan des propriétés de scintillation par rapport aux versions à base d'autres halogènes comme Cl (connu de la littérature) et Br, comme le montrent les exemples 1 et 2 comparatifs. Le résultat modeste de la version à base de l'élément chlore ne laissait pas présager d'un résultat aussi remarquable pour l'élément iode.

Le matériau selon l'invention de l'exemple 4 (Lul₃:Ce) possède aussi d'excellentes caractéristiques, notamment en pouvoir d'arrêt (ρ.Z⁴) et temps de décroissance de la composante rapide.

**Tableau 1**

| Exemple N° | Matériau scintillateur | y' (Ce³⁺) | Pouvoir, d'arrêt | Intensité d'émissions (Photons/MeV) | Résolution en Energie à 662 KeV | Composante Rapide (ns) | Pourcentage de lumière émis dans la composante rapide |
|---|---|---|---|---|---|---|---|
| 1 (comp) | K₂La_{1-y'}Cl₅: Ce_{y'} | 0,007 | 11.10⁶ | 21 000 | 5% | | |
| 2 (comp) | K₂La_{1-y'}Br₅ : Ce_{y'} | 0,007 | 13.10⁶ | 26 000 | 7% | | 40 % |
| 3 | K₂La_{1-y'}I₅ : Ce_{y'} | 0,007 | 33.10⁶ | 52 000 | 5% | 65 | 90 % |
| 4 | Lu_{1-y'}I₃ :Ce_{y'} | 0,005 | 77.10⁶ | 33 000 | | 30 | |
| 5 (comp) | Nal : Tl | - | 24.10⁶ | 40 000 | 6.5% | 230 | |

## Revendications

1. Matériau scintillateur inorganique du type iodure de formule AₓLn_{(y-y')}Ln'_{y},I_{(x+3y)} dans laquelle
- A représente au moins un élément choisi parmi Li, Na, K, Rb, Cs,
- Ln représente au moins une première terre rare choisi parmi La, Gd, Y, Lu, ladite première terre rare étant de valence 3+ dans ladite formule,
- Ln' représente au moins une deuxième terre rare choisi parmi Ce, Tb, Pr, ladite deuxième terre rare étant de valence 3+ dans ladite formule,
- x est entier et représente 0, 1, 2 ou 3,
- y est entier ou non entier et supérieur à 0 et inférieur à 3,
- y' est entier ou non entier, supérieur à 0 et inférieur à y.

2. Matériau selon la revendication précédente, **caractérisé en ce que** Ln' est le cérium (Ce).

3. Matériau selon l'une des revendications précédentes **caractérisé en ce que** y' va de 0,001 y à 0,1 y.

4. Matériau selon la revendication précédente, **caractérisé en ce que** y' va de 0,001 y à 0,01 y.

5. Matériau selon la revendication précédente, **caractérisé en ce que** y' va de 0,003 y à 0,01 y.

6. Matériau selon l'une des revendications précédentes, **caractérisé en ce que** y est égal à 1.

7. Matériau selon l'une des revendications précédentes, **caractérisé en ce que** Ln est le lanthane (La).

8. Matériau selon l'une des revendications précédentes **caractérisé en ce que** A est le potassium (K).

9. Materiau selon la revendication 6 **caractérisé en ce qu'**il est de formule
K₂La_{(1-y')}Ce_{y'}I₅.

10. Materiau selon la revendication 6 **caractérisé en ce qu'**il est de formule
Lu_{(1-y')}Ce_{y'}I₃

11. Matériau selon l'une des revendications précédentes, **caractérisé en ce qu'**il est un monocristal de volume supérieur à 10 mm³.

12. Matériau selon la revendication précédente de volume supérieur à 1 cm³.

13. Matériau selon l'une des revendications 1 à 10, **caractérisé en ce qu'**il est une poudre cristallisée ou un polycristal.

14. Procédé de fabrication d'un matériau scintillateur monocristallin selon l'une des revendication 11 ou 12, **caractérisé en ce qu'**il est obtenu par méthode de croissance Bridgman, notamment en ampoules de quartz scellées sous vide.

15. Détecteur de scintillation comprenant un matériau scintillateur selon l'une des revendications de matériau précédentes, notamment pour des applications dans l'industrie, le domaine médical et/ou la détection pour le forage pétrolier.

16. Scanner à Tomographie d'Emission de Positons comprenant un détecteur selon la revendication précédente.

17. Gamma Caméra de type Anger comprenant un détecteur selon la revendication de détecteur précédente.

## Claims

1. An inorganic scintillator material of the iodide type with formula AₓLn_{(y-y')}Ln'_{y},I_{(x+3y)} in which
- A represents at least one element chosen from Li, Na, K, Rb, Cs,
- Ln represents at least a first rare earth chosen from La, Gd, Y, Lu, said first rare earth being of valency 3+ in said formula,
- Ln' represents at least a second rare earth chosen from Ce, Tb, Pr, said second rare earth being of valency 3+ in said formula,
- x is an integer and represents 0, 1, 2 or 3,
- y is an integer or non-integer value and greater than 0 but less than 3,
- y' is an integer or non-integer value greater than 0 and less than y.

2. The material as claimed in the preceding claim, **characterized in that** Ln' is cerium (Ce).

3. The material as claimed in either of the preceding claims, **characterized in that** y' is in the range 0.001 y to 0.1 y.

4. The material as claimed in the preceding claim, **characterized in that** y' is in the range 0.001 y to 0.01 y.

5. The material as claimed in the preceding claim, **characterized in that** y' is in the range 0.003 y to 0.01 y.

6. The material as claimed in one of the preceding claims, **characterized in that** y is equal to 1.

7. The material as claimed in one of the preceding claims, **characterized in that** Ln is lanthanum (La).

8. The material as claimed in one of the preceding claims, **characterized in that** A is potassium (K).

9. The material as claimed in claim 6, **characterized in that** it has the formula
K₂La_{(1-y')}Ce_{y'}I₅.

10. The material as claimed in claim 6, **characterized in that** it has the formula
Lu_{(1-y')}Ce_{y},I₃.

11. The material as claimed in one of the preceding claims, **characterized in that** it is a single crystal and of volume greater than 10 mm³.

12. The material as claimed in the preceding claim of volume greater than 1 cm³.

13. The material as claimed in one of claims 1 to 10, **characterized in that** it is a crystallized powder or a polycrystal.

14. A method for the production of a single crystalline scintillator material as claimed in either of claims 11 and 12, **characterized in that** it is obtained by the Bridgman growth method, especially in vacuum-sealed quartz bulbs.

15. A scintillation detector comprising a scintillator material as claimed in one of the preceding material claims, especially for applications in industry, the field of medicine and/or detection for oil drilling.

16. A positron emission tomography scanner comprising a detector as claimed in the preceding claim.

17. A gamma camera of the Anger type comprising a detector as claimed in the preceding detector claim.

## Patentansprüche

1. Anorganisches Szintillatormaterial vom Typ Iodid mit der Formel AₓLn_{(y-y')}Ln'_{y},I_{(x+3y)}, in welcher
- A mindestens ein aus Li, Na, K, Rb und Cs ausgewähltes Element,
- Ln mindestens ein erstes Seltenerdmetall, das aus La, Gd, Y und Lu ausgewählt ist und dessen Wertigkeit in dieser Formel +3 beträgt,
- Ln' mindestens ein zweites Seltenerdmetall, das aus Ce, Tb und Pr ausgewählt ist und dessen Wertigkeit in dieser Formel +3 beträgt,
- x eine ganze Zahl von 0, 1, 2 oder 3,
- y gegebenenfalls eine ganze Zahl, die größer als 0 und kleiner als 3 ist, und
- y' gegebenenfalls eine ganze Zahl, die größer als 0 und kleiner als y ist,
bedeutet.

2. Material nach dem vorhergehenden Anspruch, **dadurch gekennzeichnet, dass** Ln' Cer (Ce) bedeutet.

3. Material nach einem der vorhergehenden Ansprüche, **dadurch gekennzeichnet, dass** y' 0,001y bis 0,1y beträgt.

4. Material nach dem vorhergehenden Anspruch, **dadurch gekennzeichnet, dass** y' 0,00ly bis 0,01y beträgt.

5. Material nach dem vorhergehenden Anspruch, **dadurch gekennzeichnet, dass** y' 0,003y bis 0,01y beträgt.

6. Material nach einem der vorhergehenden Ansprüche, **dadurch gekennzeichnet, dass** y gleich 1 ist.

7. Material nach einem der vorhergehenden Ansprüche, **dadurch gekennzeichnet, dass** Ln Lanthan (La) bedeutet.

8. Material nach einem der vorhergehenden Ansprüche, **dadurch gekennzeichnet, dass** A Kalium (K) bedeutet.

9. Material nach Anspruch **6, dadurch gekennzeichnet, dass** es die Formel
K₂La_{(1-y')}Ce_{y},I₅ hat.

10. Material nach Anspruch 6, **dadurch gekennzeichnet, dass** es die Formel
Lu_{(1-y')}Ce_{y},I₃ hat.

11. Material nach einem der vorhergehenden Ansprüche, **dadurch gekennzeichnet, dass** es ein Einkristall mit einem Volumen von über 10 mm³ ist.

12. Material nach dem vorhergehenden Anspruch mit einem Volumen von über 1 cm³.

13. Material nach einem der Ansprüche 1 bis 10, **dadurch gekennzeichnet, dass** es ein kristallisiertes Pulver oder ein Polykristall ist.

14. Verfahren zur Herstellung eines einkristallinen Szintillatormaterials nach Anspruch 11 oder 12, **dadurch gekennzeichnet, dass** es durch das Bridgman-Verfahren, insbesondere unter Vakuum in versiegelten Quarzampullen, erhalten wird.

15. Szintillationsdetektor, insbesondere für Verwendungen in der Industrie, auf medizinischem Gebiet und/oder für die Detektion bei Erdölbohrungen, der ein Szintillatormaterial nach einem der dieses Material betreffenden vorhergehenden Ansprüche umfasst.

16. Positronenemissionstomograph, der einen Detektor nach dem vorhergehenden Anspruch umfasst.

17. Anger-Gammakamera, die einen Detektor nach dem ihn betreffenden vorhergehenden Anspruch umfasst.
